Europäisches Patentamt

European Patent Office

Office européen des brevets

(19)

(11) Publication number: **0 034 021**
**B1**

(12)     **EUROPEAN PATENT SPECIFICATION**

(45) Date of publication of patent specification: **10.04.85**

(51) Int. Cl.⁴: **C 30 B 11/14, C 30 B 29/52**

(21) Application number: **81300395.1**

(22) Date of filing: **30.01.81**

(54) **Method of casting single crystal metal or metal alloy article.**

(30) Priority: **30.01.80 US 116879**

(43) Date of publication of application:
**19.08.81 Bulletin 81/33**

(45) Publication of the grant of the patent:
**10.04.85 Bulletin 85/15**

(84) Designated Contracting States:
**BE CH DE FR GB IT LI SE**

(56) References cited:
**US-A-4 111 252**
**US-A-4 133 368**

(73) Proprietor: **TRW INC.**
**23555 Euclid Avenue**
**Cleveland Ohio 44117 (US)**

(72) Inventor: **Vishnevsky, Constantine**
**5940 Buckboard Lane**
**Solon Ohio 44139 (US)**
Inventor: **Kolakowski, Thomas Alan**
**34900 Jackson Road**
**Moreland Hills Ohio 44022 (US)**

(74) Representative: **Spencer, Graham Easdale et al**
**A.A. Thornton & CO Northumberland House**
**303-306, High Holborn**
**London WC1V 7LE (GB)**

Courier Press, Leamington Spa, England.

# 0 034 021

**Description**

The present invention is concerned with a method of casting single crystal metal or metal alloy articles.

When molten metal solidifies against a relatively cold surface, small crystals form. As the metal continues to solidify, the initially formed crystals grow in a direction parallel to the direction of heat flow. The first formed crystals are often elongated and are commonly referred to as columnar.

In subsequent stages of solidification, when the heat flow becomes less directional, many non-elongated crystals or grains tend to form in the remaining metal. Articles produced by casting without controlling the progress of solidification in one major direction but instead allowing freezing to take place from all mould surfaces are known as equiaxed castings. In equiaxed castings, there are many crystals of a generally random orientation and little, if any, elongation of the crystals.

It has been well recognized in the art that, for certain high temperature applications, generally improved performance characteristics can be obtained by directional solidification techniques which control the shape, orientation and number of crystals. In directional solidification, a mould having a cavity which is open at the bottom is placed on a water cooled copper chill plate; the mould is heated to such a high temperature that most of the mould, except for the portion adjacent to the chill plate, is above the melting point of the metal to be cast. When a high temperature alloy is cast in such a mould, heat is extracted by the chill plate and many columnar crystals form perpendicular to the surface of the chill plate. It is a common practice to lower the chill plate from a hot zone in a furnace in a gradual manner so that the numerous columnar grains formed at the chill plate surface extend through the entire mould cavity. An apparatus for forming castings having columnar grains by this process is disclosed in U.S. Patent 3,680,625.

Greater improvements in high temperature properties can be achieved if an entire cast article is composed of a single crystal; such a casting may be obtained by selecting one of many columnar crystals or grains formed at a chill surface and allowing it to enter a mould cavity having a configuration corresponding to the configuration of the desired cast article. The particular crystal is selected using a crystal selector cavity with a geometrical shape such that one crystal is selected preferentially; examples of such selector cavities are shown in U.S. Patents 3,494,709; 3,542,120; 3,724,531; and 4,111,252.

For a crystal selector cavity to operate successfully, it is important that the formation of crystals is not initiated in the selector cavity. The initiation or nucleation of crystals in a selector cavity might occur when the inner surface of the cavity is cooled to a temperature below the melting point of the metal being cast, which could result in the growth of two or more crystals from the crystal selector cavity into a mould cavity.

Another detrimental result of initiation of crystals in the selector cavity is that the crystals will have an orientation which is not the same as those initiated at the chill plate. This can result in a single crystal casting in which the crystallographic orientation of the casting is unacceptable.

The present invention is concerned with casting of single crystal nickel-based superalloy articles using a mould having communicating starter, selector and article-forming cavities, in which the mould is heated above the liquidus temperature of the superalloy and the molten superalloy is flowed into the starter, selector and mould cavities. The formation of a plurality of crystals is initiated in the starter cavity while inhibiting initiation of crystals in the selector cavity, and crystal growth is allowed in a preferential direction such that a single crystal of superalloy is grown from the selector cavity into the article-forming cavity.

The initiation of crystals in the starter cavity while inhibiting initiation of crystals in the selector cavity is accomplished by retarding heat flow from the selector cavity in a direction transverse to the path of crystal growth and promoting heat flow from the selector cavity along the path of crystal growth.

The above-mentioned U.S. Patent 4,133,368 suggests that the thickness of the ceramic mould material around the selector cavity and the mould cavity can be varied to provide increased insulation effects and thereby minimise spurious crystal nucleation.

According to the invention, however, there is disposed, at least partially around the portion of the mould in which the selector cavity is located, fibrous ceramic thermal insulation material having a thermal conductivity of 1.44 to 4.60 J.m/sec.m$^2$.°C (1.0 to 3.2 BTU in./hr.ft.$^2$°F) in air at 982°C, which is substantially less than that of the material forming the mould, which has a thermal conductivity of 11.5 to 27.4 J.m/sec.m$^2$.°C (8 to 19 BTU in./hr.ft.$^2$°F) in air at 982°C.

The use of fibrous ceramic insulation material according to the invention results in improved inhibition of initiation of crystals in the selector cavity and enhanced initiation of crystals in the starter cavity.

The promotion of the heat flow from the selector cavity in the preferential direction of crystal growth is promoted by provision of the thermal insulation material; this is also preferably promoted by exposing the superalloy in the starter cavity to a chill plate or surface, at a temperature below the liquidus temperature.

In the following description, reference will be made to the accompanying drawings, in which:

Figure 1 is a schematic illustration of the way in which a mould supported on a chill plate is preheated in a furnace prior to pouring of molten superalloy into the mould in one embodiment of the method according to the invention; and

Figure 2 is an enlarged fragmentary view of a portion of the mould shown in Figure 1, illustrating the relationship between the starter cavity, the selector cavity and the mould cavity.

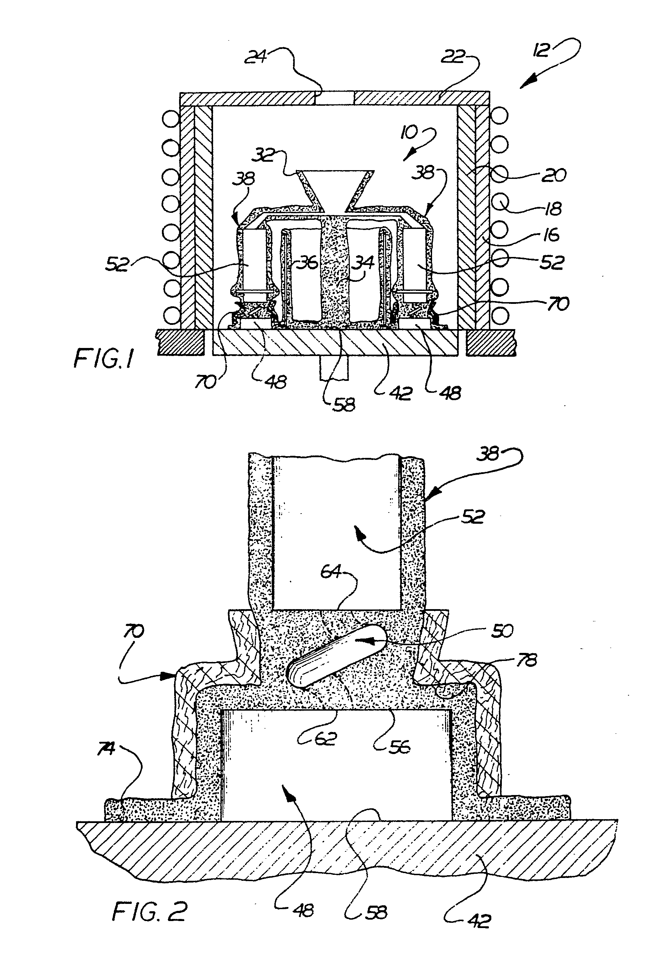

Referring to Figure 1, a mould 10 is disposed in a furnace assembly 12 in which the mould is pre-heated prior to pouring of superalloy into the mould. The furnace assembly 12 has a refractory outer wall 16

2

surrounded by an induction heating coil 18. A graphite susceptor wall 20 is enclosed by the outer wall 16 and is heated by a magnetic field from the coil 18. The furnace assembly 12 has a top plate 22 with an opening 23 through which molten superalloy can be poured into the mould 10. The entire furnace assembly 12 can be disposed within a vacuum furnace in use.

The mould 10 has a pouring basin 32 through which molten superalloy enters radially extending passages leading to mould sections 38 of ceramic mould material. A circular heat shield 36 is advantageously provided between a ceramic filled downpole 34 and the mould sections 38 which are disposed in a circular array about the downpole 34. The mould sections 38 are in fluid communication with the pouring basin 32 so that molten metal can flow from the basin into the various mould sections.

The mould 10 is disposed on a chill plate 42, which contains passages through which cold fluid can be circulated so as to cool the chill plate 42 and thereby promote the flow of heat downwardly from the mould sections 38 to the chill plate 42.

Each of the identical mould sections 38 includes a cylindrical starter cavity 48 (see Figure 2), a generally helical crystal selector cavity 50 and an article-forming cavity 52. The starter cavity 48 has a horizontal circular upper surface 56 which faces downwardly toward a horizontal upper surface 58 of the chill plate 42. The selector cavity 50 has a lower circular opening 62 which is disposed at the centre of the upper surface 56 such that, in use, columnar metal crystals from the starter cavity 48 enter the selector cavity 50 through the opening 62.

The selector cavity 50 has an upper circular opening 64 through which a single crystal of metal enters the article-forming cavity 52 in use. The article-forming cavity 52 has a configuration which corresponds to the desired configuration of an article which is to be cast as a single crystal of metal. The starter, selector and article-forming cavities 48, 50 and 52 are all in fluid communication with one another and are defined by a wall of a suitable ceramic mould material. Although the starter, selector and article-forming cavities 48, 50 and 52 may be formed in many different ways, they are generally formed in a lost wax or shell investment process by covering a wax pattern with a slurry of ceramic mould material, for example, as disclosed in U.S. Patent 4,111,252.

In carrying out the method according to the present invention, a layer of insulation material 70 is provided to extend completely around the portion of the mould section 38 containing the selector cavity 50; as illustrated, the layer of insulation material 70 also extends completely around the starter cavity 48. The layer of insulation material 70 inhibits nucleation or initiation of crystals in the selector cavity 50 to thereby enable a single crystal article having the desired crystallographic orientation to be produced in the article-forming cavity 52.

In use, the entire mould 10 is heated in the furnace assembly 12 to a temperature which is above the melting temperature of the metal which is to be cast. Molten metal is then poured through the opening 24 into the pouring basin 32. The molten metal flows from the basin 32 outwardly through radially extending passages to the various mould sections 38 and fills the starter, selector and mould cavities 48, 50 and 52 in each of the mould sections 38.

When the molten metal reaches the upper surface 58 of the chill plate 42, the metal solidifies to form many columnar crystals having longitudinal central axes which extend perpendicular to the surface 58. As is conventional, the chill plate 42 is gradually lowered from the hot zone of the furnace 12 so that the columnar grains grow upwardly toward the upper surface 56 of the starter cavity 48. As this occurs, the solid-liquid interface between the molten and solidified metal moves upwardly and remains generally parallel to the upper surface 58 of the chill plate and the upper surface 56 of the starter cavity 48.

Although a plurality of crystals enter the selector cavity 50 through the opening 62, the number of crystals which enter the selector cavity is substantially less than the total number which are formed at the chill plate 42. The crystals which enter the selector cavity 50 continue to grow vertically upwardly in the selector cavity, this vertical growth being promoted by the chill plate 42 drawing heat from the selector cavity 50 downwardly along the path of crystal growth. The vertical growth of metal crystals in the selector cavity 50 is also promoted because the heat flow in the horizontal direction from the selector cavity is retarded by the layer of thermal insulation material 70 (which tends to maintain the mould material defining the inside surfaces of the selector cavity 50 at a temperature above the melting temperature of the metal and thereby prevent initiation of crystals in the selector cavity).

The selector cavity 50 has a geometric configuration which allows the crystals to solidify only in a sideways direction in a liquid region, so that after the vertically growing crystals reach the upper surface of the helical passage forming the selector cavity 50, further growth in the selector cavity occurs only for crystals that can solidify sideways into the liquid region. Although a substantial number of crystals initially enter the selector cavity 50, competition between the crystals as the solid-liquid interface moves vertically upwardly leads to selection of only one crystal. A helical selector cavity is illustrated and described herein, but other geometric configurations can be used, if desired.

The selected crystal enters the article-forming cavity 52 through the opening 64 and then continues to solidify upwardly to form a single crystal article having a desired configuration.

Although full details of the crystal growth mechanism are not fully understood, it is believed that the layer of insulation material 70 reduces heat loss from the selector cavity 50 in a direction transverse to the path of crystal growth, thereby promoting upward growth of crystals in a manner which tends to reduce nucleation of spurious crystals in the selector cavity 50, thus promoting the entrance of a single crystal into

3

0 034 021

the article-forming cavity 52. Since this single crystal results from crystals initially formed as the upper surface 58 of the chill plate 42, the single crystal which enters the article-forming cavity 52, and thus the resulting article formed in cavity 52, will have a crystallographic orientation which can be predicted with a reasonable degree of certainty.

It is preferred that the fibrous ceramic insulation material should extend not only around the crystal selector cavity 50, but also around the starter cavity 48. Under certain circumstances it may be desirable to have the layer of fibrous ceramic insulation material formed in one or more sections with and/or without one or more spaces through which ceramic mould material is exposed.

The mould 10 may be of a conventional composition which comprises a complex aggregate of particulate ceramic held together with a binder; a particularly suitable mould material is described in U.S. Patent 4,066,116. The thermal conductivities of two exemplary known mould materials were approximately 15.8 and 23 J.m/sec.m².°C (11 and 16 BTU inch per hr.ft.²°F, respectively) in air at 1000°C (1832°F), while their densities at room temperature were from 2470 to 2630 kg/m³ (154 to 164 pounds per cubic foot) for the former mould material and 2920 to 3040 kg/m³ (182 to 190 pounds per cubic foot) for the latter mould material. Other commonly used ceramic mould materials have a thermal conductivity of 11.5 to 27.4 J.m/sec.m².°C (8 to 19 BTU in. per hr.ft.²°F) at approximately 982°C (1800°F).

Just as the mould 10 can be formed of various ceramic materials, various insulation materials 70 can be used. A ceramic (aluminosilicate) fibrous insulating material sold under the trademark Kaowool having a density in a range of from 64.1 to 192.3 kg.m⁻³, (4—12 pounds per cubic foot), preferably a density of about 128 kg.m⁻³ (about 8 pounds per cubic foot) and a thermal conductivity of between 1.73 and 3.24 J.m/sec.m².°C (1.2 to 2.25 BTU in. per hr.ft.²°F) at 982°C (1800°F) is one example of a suitable material; other examples of suitable ceramic aluminosilicate fibrous insulating materials are sold under the trade marks Fiberfrax and Fiberchrome.

The material sold under the trade mark Fiberfrax is available in blankets and felts having a density in the range 64.1 to 128.3 kg.m⁻³ (4—8 pounds per cubic foot) and a thermal conductivity which ranges from 2.3 to 3.9 J.m/sec.m².°C (1.6 to 2.7 BTU in.per.hr.ft.²°F) at 982°C (1800°F); it is also available in a coatable form having a density of from 480.8 to 801.4 kg.m⁻³ (30 to 50 pounds per cubic foot) and a thermal conductivity at 982°C (1800°F) of 2.23 to 2.49 J.m/sec.m.².°C (1.55 to 1.73 BTU in./hr. ft.²°F); the material sold as Fiberchrome is available in densities of from 48.1 to 384.7 kg.m⁻³ (2 to 24 pounds per cubic foot) and has a thermal conductivity which varies from 1.44 to 4.60 J.m/sec.m².°C (1.0 to 3.2 BTU in./hr.ft.²°F) at 982°C (1800°F).

The abovementioned insulation materials are aluminosilicates, but other ceramic insulating material could be used if desired. For example, an yttria stabilised zirconium oxide felt which is sold under the trade mark of Zircar having a density of from 240.4 to 320.6 kg.m⁻³ (15 to 20 pounds per cubic foot) and a thermal conductivity of about 1.87 J.m/sec.m².°C (1.3 BTU in./hr.ft².°F) at 982°C (1800°F) and felt produced from carbon graphite fibres, such as a felt having a density of about 85 kg.m⁻³ (5.3 pounds per cubic foot) and a thermal conductivity of about 2.5 J.m/sec.m²°C (1.8 BTU in./hr.ft²°F) at 1093°C (2000°F) in an inert gas environment, which is used to prevent the felt from burning, are also suitable.

The fibrous insulation material may be dipped in aqueous liquid binder to impart rigidity thereto on application around the selector cavity 50 and starter cavity 48. Other methods of applying the insulation material may be used; for example, mechanical devices may be used to connect the insulation material to the mould section 38.

Experiments were conducted to ascertain the optimum thickness for the insulation material 70; in one experiment, a mould 10 having twelve sections 38 was utilized. A 7.6 cm (3 inches) thick layer of a dry ceramic fibrous insulation material having a density of 128.3 kg.m⁻³ (8 pounds per cubic foot), sold under the Trade Mark Kaowool was loosely piled around the bottom of the mould 10. (The same insulation material was used in the subsequently described experiments).

The insulation material was loosely piled such that it reached upwardly from an upper surface of a bottom wall 74 (see Figure 2) of the mould 10 to the upper end of the selector cavity 50 of each of the mould sections 38, so that the starter cavity 48 and selector cavity 50 of each mould section 38 was surrounded by an insulating layer having a horizontal extent which was at least as great as the horizontal extent of the mould 10.

Thermocouples were mounted on the outside of a mould section 38 at a vertical height of 0.5, 1.5 and 2.5 inches (1.27 cm, 3.81 cm and 6.35 cm, respectively) from the upper surface of the bottom wall 74. The bottom wall 74 of the mould 10 had a thickness of approximately 0.25 inches (0.63 cm) so that the thermocouples were located at distances of approximately 0.75, 1.75 and 2.75 inches (1.90 cm, 4.44 cm and 6.98 cm, respectively) from the upper surface 58 of the chill plate 42. The upper surface of the insulation material surrounding the mould section 38 was located at a height of three inches (7.6 cm) above the upper surface of the mould wall 74 or at a height of 3.25 inches (8.23 cm) from the upper surface 58 of the chill plate 42.

The mould 10 was then preheated to a peak temperature within the furnace 12 of approximately 2750°F (1510°C) and was held close to this temperature for a period of approximately twenty minutes prior to pouring the molten alloy (a nickel base superalloy having a composition within the following range: 8.0 to 10.5% chromium, 3.75 to 12.5% tungsten, 0.9 to 2.25% titanium, 4.75 to 5.70% aluminium, and also containing not in excess of 11% cobalt, 1.25% columbium, 12.25% tantalum, 1.6% hafnium, 0.8%

4

**0 034 021**

molybdenum, 0.17% carbon, 0.02% boron, and 0.08% zirconium; the balance of the alloy being essentially nickel). The molten alloy was poured at a temperature of 2800°F (1538°C), well above the metal melting point (liquidus) of about 2500°F (1370°C). After the molten alloy had been poured, the mould 10 was gradually withdrawn from the hot zone of the furnace assembly 12 at a rate of approximately three inches (7.6 cm) per hour while maintaining the peak hot zone temperature at 2750°F (1510°C).

One of the twelve mould sections 38 leaked metal so that only eleven castings of the twelve poured were available for examination; the eleven castings were examined conventionally, by acid etching, to reveal the number, shape and alignment of the crystals, showing that all of the castings were unsatisfactory. Eight of the eleven castings were multigrained and the other three had crystallographic orientations which were off axis.

It is believed that this high scrap rate resulted from spurious nucleation in the selector cavity 50, possibly as a result of the temperature in the selector cavity being well below the liquidus temperature of the molten alloy. Immediately before pouring of the molten alloy, the thermocouple on the outside of the mould section 38 at a height of 0.5 inches (1.27 cm) from the top of the bottom wall 74 indicated a temperature of approximately 550°F (288°C), while the thermocouple which was located 1.5 inches (3.81 cm) from the top of the bottom wall 74 indicated a temperature of approximately 900°F (482°C) and the thermocouple which was 2.5 inches (6.35 cm) above the bottom wall indicated a temperature of 2375°F (1301°C). It is believed that these relatively low temperatures indicate that the starter cavity 48 and the selector cavity 50 were, immediately prior to pouring of the molten alloy below the liquidus temperature (1370°C), causing initiation of crystals in the selector cavity 50. This may be because the layer of thermal insulation material was too thick.

We therefore evaluated other different thicknesses of the insulating layer 70, as follows: a mould 10 having eleven mould sections 38 disposed in a circular array was used, two of the mould sections 38 being left free of insulation; a layer of insulation material of thickness 1/8 inch (0.32 cm) being applied over two mould sections; a layer of insulation material 1/4 inch (0.63 cm) thick being applied over one mould section 38; a layer of insulation material 1/2 inch (1.27 cm) thick being applied over two mould sections 38; and layers of insulation material having thicknesses of 3/4 inch (1.89 cm), one inch (2.54 cm), 1 1/2 inches (3.81 cm) and two inches (5.08 cm) were applied over four respective mould sections 38.

Each layer of insulation material surrounded the starter and selector cavities 48 and 50 in the manner shown in Figure 2. The insulation material was as used in the preivous experiment; to facilitate adhesion thereof to the mould surfaces, the insulation material was first dipped in an aqueous colloidal silica binder, which when dry, imparts rigidity to the insulating material.

Thermocouples were connected to the outside of the mould sections 38 which were free of insulating material, and to the outside of the mould sections in which the 1/4 inch, 1/2 inch, one inch, and two inch thick layers of insulation material were applied. The thermocouples were all located on an upper surface of the horizontally extending shoulder 78 (see Figure 2) at the junction between the starter cavity 48 and selector cavity 50, that is, approximately one inch (2.54 cm) from the upper surface of the bottom wall 74 of the mould 10 or approximately 1.25 inches (3.17 cm) from the upper surface 58 of the chill plate 42.

After preheating of the mould 10 to a temperature of approximately 2750°F (1510°C) for twenty minutes, a molten nickel-based superalloy metal as used in the previously described experiment was poured into the mould at a temperature of approximately 2800°F (1538°C). After pouring, the mould was gradually withdrawn at a rate of three inches (7.6 cm) per hour from the hot zone of the furnace with the peak hot zone temperature at approximately 2750°F (1510°C). (The conditions under which the second experiment was performed were substantially the same as the conditions under which the first experiment was performed).

During the second experiment, the mould sections 38 having a layer of insulating material 1/2 inch thick and one inch thick ran out so that castings were not obtained from these mould sections. An examination of the castings from the other mould sections 38 yielded the following results:

5

# 0 034 021

| Insulation material thickness | Casting characteristics |
|---|---|
| None | Single crystal casting oriented 20° off the desired crystallographic axis. |
| 1/8 inch (0.32 cm) | Single crystal casting with satisfactory crystallographic orientation. |
| 1/4 inch (0.63 cm) | Single crystal casting having satisfactory crystallographic orientation. |
| 3/4 inch (1.89 cm) | Single crystal casting with unacceptable crystallographic orientation. |
| 1 1/2 inches (3.81 cm) | Multiple crystal casting— unsatisfactory. |
| 2 inches (5.08 cm) | Single crystal casting with very unsatisfactory crystallographic orientation. |

Thermocouple readings were taken to determine the temperature of the outside of the mould sections 38 immediately prior to pouring of the molten alloy, at the start of the withdrawal of the mould from the hot zone of the furnace after pouring of the alloy and 25 minutes after the pouring of the molten alloy. The results of these temperature measurements were as follows:

| Insulation material thickness | Before pour | Start of withdrawal | 25 Minutes after pour |
|---|---|---|---|
| None | 2495°F (1368°C) | 2510°F (1376°C) | 2350°F (1288°C) |
| 0.63 cm | 2270°F (1243°C) | 2290°F (1254°C) | 2210°F (1210°C) |
| 1.27 cm | 2260; 2170°F (1237; 1188°C) | 2440; 2380°F (1338; 1304°C) | 2290; 2200°F (1254; 1204°C) |
| 2.54 cm | 640°F (338°C) | 800°F (427°C) | 940°F (504°C) |
| 5.08 cm | 580°F (304°C) | 700°F (371°C) | 680°F (360°C) |

As a result of the second experiment it is believed that the insulating material should have a thickness of between 1/8 inch (0.32 cm) and 1 1/2 (3.81 cm); the actual thickness used depending upon the specific composition of the alloy which is poured and other variables. The selection of a particular thickness of insulation material will, to some extent at least, be influenced by the geographic configuration of the selector cavity 50 and its orientation relative to the starter cavity 48 and the thickness of the ceramic mould material used to form the mould sections 38. However, it is believed that perhaps the most significant variables governing the choice of thickness are the specific composition of the insulation and of the alloy being poured (the latter alloy being preferably a nickel-based superalloy).

A third experiment was performed using a mould 10 having nineteen sections 38 of the same general construction as the mould sections which were used in the previous experiments. Of the 19 sections, one of them had a run out during the casting process so that a casting was not obtained.

During the third experiment, layers of insulation material each having a thickness of 1/4 inch (0.63 cm) were applied around the selector cavity 50 and starter cavity 48 of twelve of the mould sections 38 in the manner shown in Figure 2 of the drawings; the other six mould sections 38 were left free of insulation material.

Castings were made using the same alloy and conditions as described above; of the twelve castings made with the 1/4 inch thick layer of insulation material, eleven were single crystal castings having the desired crystallographic orientation, while of the six castings which were made without any insulation, only one casting was a single crystal casting with the desired crystallographic orientation.

6

**Claims**

1. A method of casting a single crystal nickel-based superalloy article in a mould having a starter cavity in communication with a crystal selector cavity which is in communication with an article-forming cavity, which comprises heating the mould above the liquidus temperature of the superalloy, flowing the molten superalloy into said cavities, cooling the superalloy in the starter cavity so as to initiate crystal formation therein, and allowing crystal growth in a preferential direction into the selector cavity and then into the article-forming cavity, initiation of crystal formation in the selector cavity being inhibited and crystal growth therein in said preferential direction being promoted by providing increased thermal insulation around the mould, the material forming the mould having a thermal conductivity of 11.5 to 27.4 J.m/sec.m$^2$.°C (8 to 19 BTU in./hr. ft.$^2$°F) in air at 982°C (1800°F) characterised in that additional thermal insulation material is provided at least partially around that part of the mould containing the selector cavity, said thermal insulation material being a fibrous ceramic material having a thermal conductivity of 1.44 to 4.60 J.m/sec.m$^2$.°C (1.0 to 3.2 BTU in./hr.ft.$^2$°F) in air at 982°C.

2. A method according to claim 1 characterised in that the thermal insulation material is provided partially around that part of the mould containing the starter cavity.

3. A method according to claim 1 or 2 characterised in that crystal growth in said preferential direction is promoted by exposing a part of the starter cavity to a surface at a temperature below said liquidus temperature.

**Revendications**

1. Procédé de coulée d'une pièce monocristalline en alliage à base de nickel dans un moule comprenant une cavité de formation initiale de cristaux se trouvant en communication avec une cavité sélectrice de cristal qui est en communication avec une cavité ou empreinte de mise en forme de la pièce, lequel procédé consiste à chauffer le moule au-delà de la température de liquidus du superalliage, à couler le superalliage fondu dans lesdites cavités, à refroidir le superalliage dans la cavité de formation initiale de cristaux de façon à déclencher la formation de cristaux, et à permettre une croissance de cristaux dans une direction préférentielle à l'intérieur de la cavité sélectrice et ensuite à l'intérieur de la cavité ou empreinte de mise en forme de la pièce, un début de formation de cristaux dans la cavité sélectrice étant empêché et une croissance de cristaux à l'intérieur de cette dernière dans ladite direction préférentielle étant favorisée en prévoyant une isolation thermique accrue autour du moule et la matière constitutive du moule présentant une conductivité thermique de 11,5 à 27,4 J.m/s.m$^2$.°C (8 à 19 BTU pouce/h.pied$^2$.°F) dans de l'air à 982°C (1800°F), caractérisé en ce que de la matière thermiquement isolante additionnelle est prévue au moins partiellement autour de la partie du moule qui contient la cavité sélectrice, cette matière thermiquement isolante étant une matière céramique fibreuse présentant une conductivité thermique de 1,44 à 4,60 J.m/s.m$^2$.°C (1,0 à 3,2 BTU pouce/h.pied$^2$.°F) dans de l'air à 982°C.

2. Procédé selon la revendication 1, caractérisé en ce que la matière thermiquement isolante est prévue partiellement autour de la partie du moule qui contient la cavité de formation initiale de cristaux.

3. Procédé selon la revendication 1 ou 2, caractérisé en ce que la croissance de cristaux dans la direction préférentielle précitée est favorisée en exposant une partie de la cavité de formation initiale de cristaux à une surface se trouvant à une température inférieure à ladite température de liquidus.

**Patentansprüche**

1. Verfahren zum Gießen einkristalliner Gegenstände aus einer hochwarmfesten Nickellegierung in einer Form, welche einen Start-Hohlraum in Verbindung mit einem Hohlraum für die Kristallauswahl aufweist, welcher seinerseits in Verbindung steht mit dem Formhohlraum, in dem die Form über die Liquidustemperatur der hochwarmfesten Legierung erhitzt wird, die Legierungsschmelze in die Hohlräume fließt, die Schmelze in dem Start-Hohlraum zur Kristallbildung abgekühlt wird, das Kristallwachstum in bevorzugter Richtung in den Kristallauswahl-Hohlraum durch verstärkte Wärmeisolierung um die Form begünstigt wird und die Form aus einem Werkstoff besteht, dessen Wärmeleitfähigkeit 11,5 bis 27,1 J.m/s.m$^2$.K (8 bis 19 BTU in./ft$^2$°F) in Luft von 982°C (1800°F) beträgt, dadurch gekennzeichnet, daß zusätzliches Wärmeisoliermaterial zumindest teilweise um den Teil der Form, der den Kristallauswahl-Hohlraum umfaßt, vorgesehen ist und das Wärmeisoliermaterial Keramikfasern mit einer Wärmeleitfähigkeit von 1,44 bis 4,60 J.m/s.m$^2$.K (1 bis 3,2 BUT in./hr.ft.$^2$°F) in Luft bei 982°C ist.

2. Verfahren nach Anspruch 1, dadurch gekennzeichnet, daß das Wärmeisoliermaterial teilweise um den Teil der Form, der den Start-Hohlraum umschließt, vorgesehen ist.

3. Verfahren nach Anspruch 1 oder 2, dadurch gekennzeichnet, daß das Kristallwachstum in Vorzugsrichtung begünstigt wird, indem ein Teil des Start-Hohlraums einer Fläche mit einer Temperatur unter der Liquidustemperatur ausgesetzt wird.

FIG. 1

FIG. 2